# EUROPEAN PATENT APPLICATION

(11) **EP 4 401 121 A1**
(43) Date of publication of application: **17.07.2024**
(21) Application number: 24150760.7
(22) Date of filing: 08.01.2024
(51) Int. Cl.: H01L 21/768, H01L 23/48, H01L 23/485, H01L 23/528, H01L 25/065

(54) **SEMICONDUCTOR DEVICE**

(30) Priority: 10.01.2023 KR 20230003346
(71) Applicant: Samsung Electronics Co., Ltd., Suwon-si, Gyeonggi-do 16677 (KR)
(72) Inventor: YOU, Wookyung, 16677 Suwon-si (KR); KIM, Yeonggil, 16677 Suwon-si (KR); KANG, Sangkoo, 16677 Suwon-si (KR); KANG, Minjae, 16677 Suwon-si (KR); RYU, Koungmin, 16677 Suwon-si (KR); SEO, Hoonseok, 16677 Suwon-si (KR); LEE, Woojin, 16677 Suwon-si (KR)
(74) Representative: Marks & Clerk LLP

(57) **Abstract**

A semiconductor device includes: a device structure including a first semiconductor substrate and having an active pattern extending in first direction, a conductive through-via electrically connected to a front wiring layer and penetrating through the first semiconductor substrate, wherein the first semiconductor substrate has a non-planarized lower surface in which a peripheral region around the conductive through-via curves downward, a first bonding structure having a planarized insulating layer disposed on the second surface of the first semiconductor substrate and having a planarized upper surface.

## Description

The present disclosure relates to a semiconductor device.

In various semiconductor devices such as logic circuits and memories, active regions such as sources and drains are connected to a metal wiring of a Back End of Line (BEOL) through a contact structure. A method of forming a conductive penetration structure penetrating through a semiconductor substrate has been required to locate at least some wirings of the BEOL (e.g., a power line) on a backside of the substrate and make a connection with some wirings.

### SUMMARY

An aspect of the present disclosure is to provide a semiconductor device configured to improve connection reliability by simplifying a structure of a conductive through-via.

Provided herein is a semiconductor device including: a first semiconductor substrate having a first surface and a second surface disposed opposite to each other and having an active pattern extending on the first surface in a first direction; a gate structure disposed in one region of the active pattern and extending in a second direction intersecting the first direction; a source/drain region disposed in the active pattern on a side of the gate structure; an interlayer insulating film disposed on the first semiconductor substrate and covering the source/drain region; a contact structure penetrating through the interlayer insulating film and connected to the source/drain region; a front wiring structure having a front insulating layer disposed on the interlayer insulating film and a front wiring layer disposed in the front insulating layer and electrically connected to the contact structure; a conductive through-via electrically connected to the contact structure or the front wiring layer and penetrating through the interlayer insulating film and the first semiconductor substrate, wherein the second surface of the first semiconductor substrate has a non-planarized surface in a region around the conductive through-via, wherein the second surface curves downward thereby forming a dishing portion; a planarized insulating layer disposed on the second surface of the first semiconductor substrate and having a lower surface on substantially a same level as a bottom of the conductive through-via; and a backside wiring structure having a backside insulating layer disposed on the planarized insulating layer and a backside metal, wherein the backside metal is disposed in the backside insulating layer and connected to the bottom of the conductive through-via.

Also provided herein is a semiconductor device including: a first semiconductor substrate having a first surface and a second surface disposed opposite to each other and having an active pattern extending on the first surface in a first direction; a gate structure disposed in a portion of the active pattern and extending in a second direction intersecting the first direction; a source/drain region disposed in the active pattern on a side of the gate structure; an interlayer insulating film disposed on the first semiconductor substrate and covering the source/drain region; a contact structure penetrating through the interlayer insulating film and connected to the source/drain region; a first wiring structure having a first insulating layer disposed on the interlayer insulating film and a first wiring layer disposed in the first insulating layer and electrically connected to the contact structure; a conductive through-via electrically connected to the first wiring layer and penetrating through the interlayer insulating film and the first semiconductor substrate, wherein the conductive through-via has a protruding portion protruding from the second surface of the first semiconductor substrate and the second surface of the first semiconductor substrate has a non-planarized surface in a region around the protruding portion, wherein the second surface curves downward thereby forming a dishing portion; a planarized insulating layer disposed on the second surface of the first semiconductor substrate, and surrounding the protruding portion of the conductive through-via, the planarized insulating layer having a surface substantially coplanar with a contact region of the conductive through-via; a first bonding structure having a first bonding insulating layer disposed on the planarized insulating layer, and a first bonding pad embedded in the first bonding insulating layer and connected to the contact region of the conductive through-via; an etch stop layer disposed between the planarized insulating layer and the first bonding insulating layer and including a material different from the first bonding insulating layer; a second bonding structure disposed on the first bonding structure, and having a second bonding insulating layer bonded to the first bonding insulating layer and a second bonding pad embedded in the second bonding insulating layer and bonded to the first bonding pad; a second wiring structure disposed on the second bonding structure, and having a second wiring layer connected to the second bonding pad; and a second semiconductor substrate having a contact via disposed on the second wiring structure and electrically connected to the second wiring layer.

Yet another semiconductor device is provided herein, the semiconductor device including: a device structure including a first semiconductor substrate having a first surface and a second surface disposed opposite to each other and having an active pattern extending from the first surface in first direction, an interlayer insulating film disposed on the active pattern, a first wiring layer disposed on the interlayer insulating film, and a conductive through-via electrically connected to the first wiring layer and penetrating through the interlayer insulating film and the first semiconductor substrate, wherein the second surface of the first semiconductor substrate has a non-planarized surface in a region around the conductive through-via, wherein the second surface curves downward; a first bonding structure including a planarized insulating layer disposed on the second surface of the first semiconductor substrate and having a planarized upper surface, a first bonding insulating layer disposed on an upper surface of the planarized insulating layer, and a first bonding pad embedded in the first bonding insulating layer and connected to the conductive through-via; a second bonding structure disposed on the first bonding structure, and including a second bonding insulating layer bonded to the first bonding insulating layer and a second bonding pad embedded in the second bonding insulating layer and bonded to the first bonding pad; a power supply structure including a second wiring layer disposed on the second bonding structure and a second semiconductor substrate with a contact via connected to the second wiring layer; and a support structure disposed on the first wiring layer of the device structure.

According to the aforementioned example embodiments, in a polishing process of a semiconductor substrate to expose a conductive penetration structure from a backside of the semiconductor substrate, a planarized insulating layer may be formed on a non-planarized surface obtained by a difference in a selection ratio between a conductive through-via and the semiconductor substrate, and a reliable backside metal may be formed on the planarized insulating layer. Through such a planarization process, defects such as leakage current between the backside metal and the semiconductor substrate, which may occur in a non-planarized region around the conductive through-via, may be prevented.

Advantages and effects of the present application are not limited to the foregoing content and may be more easily understood in the process of describing a specific example embodiment of the present disclosure.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a plan view illustrating a semiconductor device according to an example embodiment of the present disclosure;
FIG. 2 is a cross-sectional view of the semiconductor device illustrated in FIG. 1 taken along lines I1-I1' and II1-II1';
FIG. 3 is an enlarged cross-sectional view illustrating part "A1" of the semiconductor device illustrated in FIG. 2;
FIGS. 4A and 4B are partially enlarged views of a semiconductor device according to an example embodiment of the present disclosure, respectively;
FIG. 5 are cross-sectional views illustrating a semiconductor device according to an example embodiment of the present disclosure;
FIG. 6 is an enlarged cross-sectional view illustrating part "A2" of the semiconductor device illustrated in FIG. 5;
FIG. 7 is a plan view illustrating a semiconductor device according to an example embodiment of the present disclosure;
FIG. 8 is cross-sectional views of the semiconductor device illustrated in FIG. 7 taken along lines I2-I2' and II2-II2';
FIGS. 9A to 9H are cross-sectional views for each main process for describing some processes (e.g., device structure manufacturing processes) of a method of manufacturing the semiconductor device illustrated in FIG. 8; and
FIGS. 10A and 10B are cross-sectional views for each main process for explaining some other processes (e.g., bonding processes) of the method of manufacturing the semiconductor device illustrated in FIG. 8.

### DETAILED DESCRIPTION

Hereinafter, example embodiments of the present disclosure will be described with reference to the accompanying drawings.

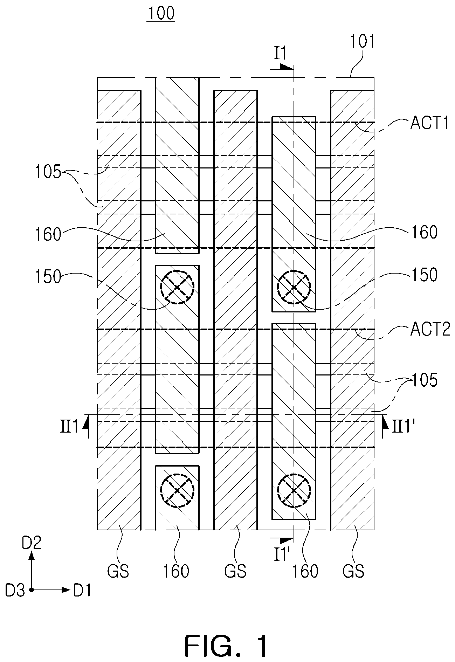

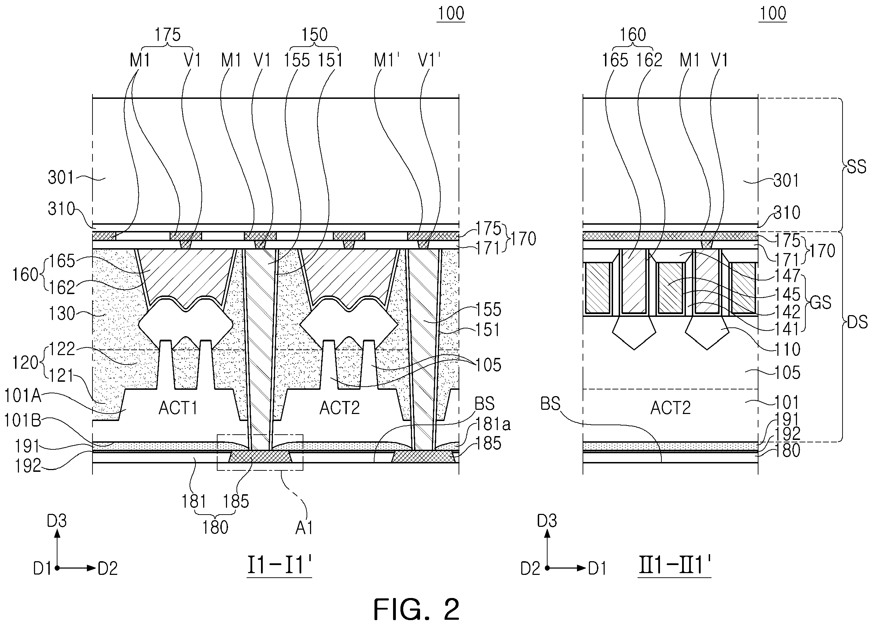

FIG. 1 is a plan view illustrating a semiconductor device according to an example embodiment of the present disclosure, and FIG. 2 is a cross-sectional view of the semiconductor device illustrated in FIG. 1 taken along lines I1-I1' and II1-II1'.

Referring to FIGS. 1 and 2, a semiconductor device 100 according to an example embodiment of the present disclosure includes a device structure DS having a first semiconductor substrate 101, and a support structure SS disposed on the device structure DS.

The device structure DS includes the first semiconductor substrate 101 having a first surface 101A with active regions ACT1 and ACT2 and a second surface 101B disposed opposite the first surface 101A, a plurality of active patterns 105 protruding from upper surfaces of the active regions ACT1 and ACT2 and extending in a first direction (e.g., D1), a gate structure GS disposed in a region of the plurality of active patterns 105 and extending in a second direction (e.g., D2) intersecting the first direction (e.g., D1), and source/drain regions 110 disposed in the plurality of active patterns 105 at both sides of the gate structure GS.

The first semiconductor substrate 101 may include semiconductors such as Si or Ge, or compound semiconductors such as SiGe, SiC, GaAs, InAs, or InP. The active regions ACT1 and ACT2 may be conductive regions such as an impurity-doped well or an impurity-doped structure. The active region adopted in an example embodiment of the present disclosure may include a first active region ACT1 and a second active region ACT2 which are different conductivity types. For example, the first active region ACT1 may be an N-type well for a PMOS transistor, and the second active region ACT2 may be a P-type well or a P-type substrate for an NMOS transistor.

Each of the plurality of active patterns 105 has a structure protruding upward (e.g., D3) from the upper surfaces of the first and second active regions ACT1 and ACT2, and is also referred to as an "active fin."

Referring to FIG. 1, the plurality of active patterns 105 may be arranged in parallel on the upper surfaces of the first and second active regions ACT1 and ACT2 and may extend in the first direction (e.g., D1). The plurality of active patterns 105 may be provided as active regions of each transistor. In this example embodiment, the plurality of active patterns 105 are exemplified in the form in which two active patterns 105 are provided to the source/drain regions 110, but the present disclosure is not limited thereto, and in other example embodiments, a single number or three or more may be provided.

The source/drain regions 110 may be formed in some regions of the plurality of active patterns 105 disposed at both sides of the gate structure GS, respectively. In an example embodiment of the present disclosure, the source/drain regions 110 may form a recess in some regions of the plurality of active patterns 105 and have an upper surface on a higher level than upper surfaces of the plurality of active patterns 105 through selective epitaxial growth (SEG). The source/drain regions 110 are also referred to as a raised source/drain (RSD) regions. For example, the source/drain regions 110 may be Si, SiGe, or Ge, and may have either N-type or P-type conductivity. In some example embodiments, the P-type source/drain regions 110 include SiGe with P-type impurities, for example, boron (B), indium (In), gallium (Ga), boron trifluoride (BF3), and the like, may be doped. In some example embodiment, the N-type source/drain regions 110 include silicon (Si), with N-type impurities, for example, phosphorus (P), nitrogen (N), arsenic (As), antimony (Sb), and the like, may be doped. The source/drain regions 110 may have different shapes along a crystallographically stable plane during the growth process. For example, the source/drain regions 110 may have a pentagonal cross-section. In contrast, when the second active region ACT2 is N-type, the source/drain regions 110 on the second active region ACT2 may have a hexagonal cross-section or a polygonal cross-section having gentle angles.

The device structure DS may include a device isolation film 120. The device isolation film 120 may include a first isolation region 121 defining the first and second active regions ACT1 and ACT2, and a second isolation region 122 defining the plurality of active patterns 105. The first isolation region 121 has a bottom surface deeper than that of the second isolation region 122. The first isolation region 121 is also referred to as deep trench isolation (DTI), and the second isolation region 122 is also referred to as shallow trench isolation (STI). The second isolation region 122 may be disposed on the upper surfaces of the first and second active regions ACT1 and ACT2. A portion of the active pattern 105 may protrude above the second isolation region 122.

For example, the device isolation film 120 may include silicon oxide or silicon oxide-based insulating materials, specifically, Tetra Ethyl Ortho Silicate (TEOS), Undoped Silicate Glass (USG), PhosphoSilicate Glass (PSG), Borosilicate Glass (BSG), BoroPhosphoSilicate Glass (BPSG), Fluoride Silicate Glass (FSG), Spin On Glass (SOG), Tonen SilaZane (TOSZ), or combinations thereof. The device isolation film 120 may be formed using chemical vapor deposition (CVD) or a spin coating process.

The gate structure GS illustrated in FIG. 1 has a line shape extending in the second direction (e.g., D2), and may overlap one region of the active pattern 105. The gate structures GS adopted in an example embodiment of the present disclosure may include gate spacers 141, a gate insulating film 142 and a gate electrode 145 sequentially arranged between the gate spacers 141, and a gate capping layer 147 disposed on the gate electrode 145. For example, the gate spacers 141 may include insulating materials such as SiOCN, SiON, SiCN, or SiN. For example, the gate insulating film 142 may include a silicon oxide film, a high dielectric film, or combinations thereof. The high dielectric film may include a material having a higher dielectric constant (e.g., about 10 to 25) than the silicon oxide film. For example, the high dielectric film may be formed of a material selected from hafnium oxide, hafnium oxynitride, hafnium silicon oxide, lanthanum oxide, lanthanum aluminum oxide, and combinations thereof, but the present disclosure is not limited thereto. The gate insulating film 142 may be formed by an atomic layer deposition (ALD) process, a chemical vapor deposition (CVD), or a physical vapor deposition process.

In some example embodiments, the gate electrode 145 may include first and second gate electrodes made of different materials. The first gate electrode may adjust a work function and fill a space formed in an upper portion of the first gate electrode. For example, the first gate electrode may include a metal nitride such as a titanium nitride film (TiN), a tantalum nitride film (TaN) or a tungsten nitride film (WN), and the second gate electrode may include a metal material such as aluminum (Al), tungsten (W) or molybdenum (Mo), or a semiconductor material such as doped polysilicon. For example, the gate capping layer 147 may include an insulating material such as silicon nitride.

An interlayer insulating film 130 may be disposed on the device isolation film 120 to cover the source/drain regions 110. The interlayer insulating film 130 may have an upper surface that is substantially planar and coplanar with an upper surface of the gate capping layer 147. The interlayer insulating film 130 may be formed of the same or similar material as the above-described material of the device isolation film 120. In some example embodiments, the interlayer insulating film 130 may be formed in a process different from that of the device isolation film 120 to have a different film quality.

A contact structure 160 may be connected to the source/drain regions 110 by penetrating through the interlayer insulating film 130. The contact structure 160 may include a contact plug 165 and a conductive barrier 162 disposed on a side surface and a lower surface of the contact plug 165. For example, the contact plug 165 may include Cu, Co, Mo, Ru, W, or alloys thereof. For example, the conductive barrier 162 may include Ta, TaN, Mn, MnN, WN, Ti, TiN, or combinations thereof. The contact structure 160 may include a metal silicide layer (not illustrated) disposed between the conductive barrier 162 and the source/drain regions 110. For example, the metal silicide layer may be formed of a material such as CoSi, NiSi, or TiSi. The contact structure 160 may have an upper surface having the same level as an upper surface of the interlayer insulating film 130.

A first wiring structure 170 (also called a front wiring structure) may be formed on the interlayer insulating film 130. The first wiring structure 170 includes a first insulating layer 171 and a first or front wiring layer 175. The layer 171 may comprise a plurality of insulating and/or dielectric layers and the first wiring layer 75 may be contained wholly or partially within one or more of the layers 171. The first wiring layer 175 may include a first metal line M1 and a first metal via V1. The first wiring layer 175 may be configured to be electrically connected to the contact structure 160 and a conductive through-via 150. In this example embodiment, the first wiring layer 175 is illustrated as being directly connected to the contact structure 160 through the first metal via V1, but in another example embodiment, the first wiring layer 175 may be configured to be directly connected to the conductive through-via 150 through the first metal via V1. For example, the first wiring layer 175 may be formed using a dual damascene process. In this example embodiment, the first wiring layer 175 is illustrated as a single layer structure, but in some example embodiments, the first wiring layer 175 may be implemented as a multilayer structure.

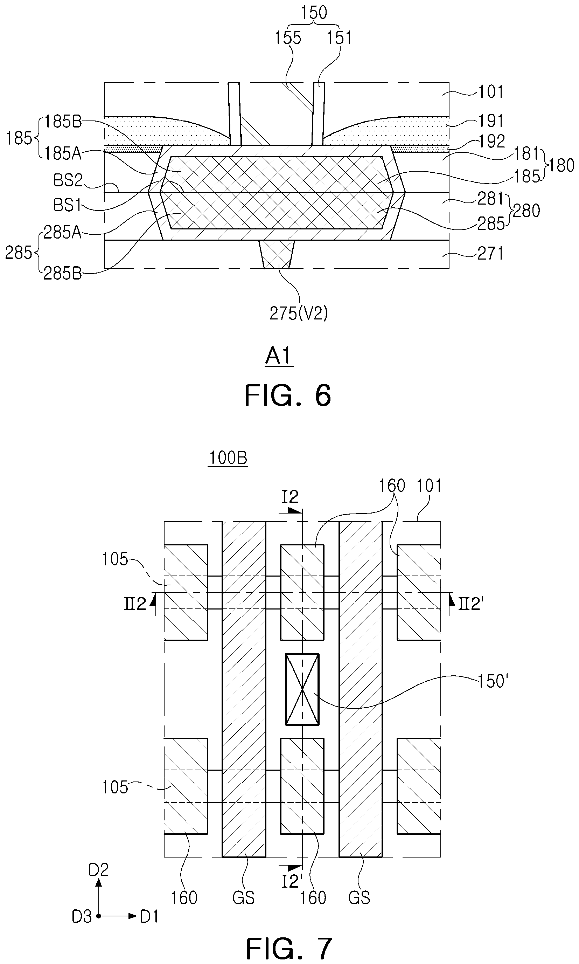

The device structure DS according to an example embodiment of the present disclosure includes the interlayer insulating film 130 and the conductive through-via 150 penetrating through the first semiconductor substrate 101. For example, the conductive through-via 150 may be a through silicon via (TSV). In this example embodiment, the conductive through-via 150 is exemplified as having a nearly cylindrical structure, but may have a rail structure extending in a certain direction (e.g., a second direction) (see FIG. 7).

The conductive through-via 150 may also penetrate through the device isolation film 120 disposed between the interlayer insulating film 130 and the first semiconductor substrate 101. In this example embodiment, the conductive through-via 150 may be formed in a substrate region between the first and second active regions ACT1 and ACT2, but the present disclosure is not limited thereto, and in some example embodiments, the conductive through-via may be formed in the active regions.

The conductive through-via 150 may be formed from the interlayer insulating film 130 before forming the front wiring structure 170 (or also referred to as the 'first wiring structure'). The conductive through-via 150 may have a narrower width as it approaches the second surface 101B of the first semiconductor substrate 101 by a formation direction thereof. The conductive through-via 150 may include a conductive material 155, and an insulating barrier 151 disposed between the conductive material 155 and the first semiconductor substrate 101. For example, the conductive material 155 may include Cu, Co, Mo, Ru, W, or alloys thereof. For example, the insulating barrier 151 may include SiO₂, SiN, SiCN, SiC, SiCOH, SiON, Al₂O₃, or AlN.

In an example embodiment of the present disclosure, the conductive through-via 150 may be connected to the first wiring layer 175 of the first wiring structure 170. A portion of the first metal line M1' and a portion of the first metal via V1' may be connected to an upper surface of the conductive through-via 150. The conductive through-via 150 may have an upper surface having the same level as an upper surface of the contact structure 160. The conductive through-via 150 may also be electrically connected to the contact structure 160 and the active pattern 105 of other devices through the first wiring layer 175.

A lower surface (or a contact region) of the conductive through-via 150 may be exposed from the second surface 101B of the first semiconductor substrate 101. The second surface 101B of the first semiconductor substrate 101 may have a non-planarized surface in which a peripheral region around the conductive through-via 150 curves downward toward a backside metal thereby forming a dishing portion - in other words, the first semiconductor substrate 101 may have a non-planarized surface in which a peripheral region around the conductive through-via 150 is higher than other regions. In order to planarize such a non-planarized surface, a planarized insulating layer 191 may be formed over the second surface 101B of the first semiconductor substrate 101. In general, "to planarize" means "to flatten" and "planarized" means "flattened." A backside wiring structure 180 may be easily formed on an upper surface planarized by the planarized insulating layer 191.

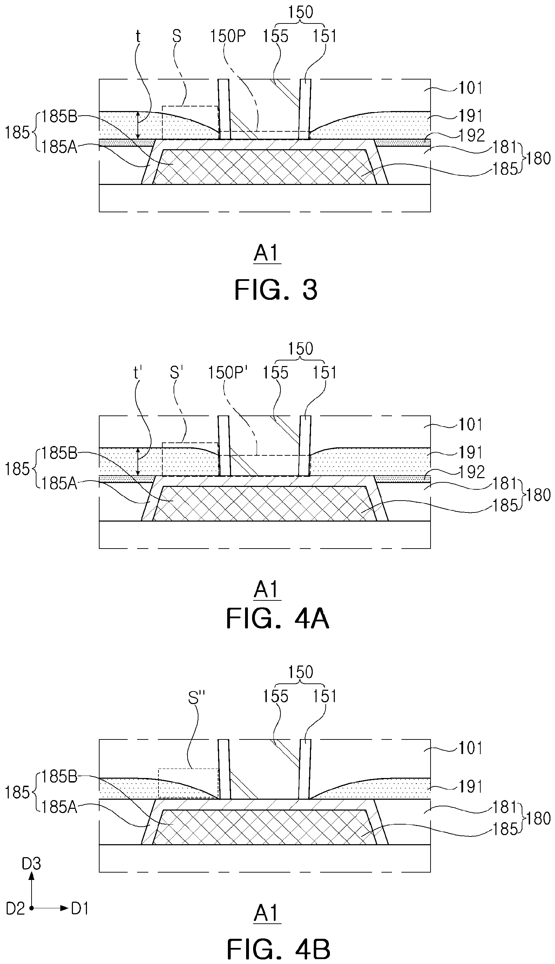

FIG. 3 is an enlarged cross-sectional view illustrating part "A1" of the semiconductor device 100 illustrated in FIG. 2.

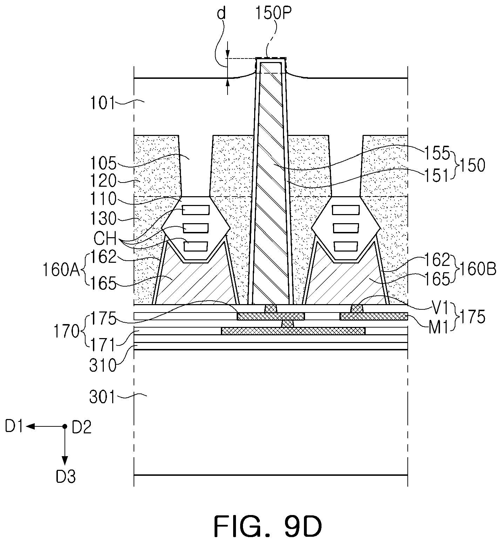

Referring to FIG. 3, the conductive through-via 150 may have a protruding portion 150P slightly protruding from the second surface 101B of the first semiconductor substrate 101. The protruding portion 150P may provide a contact region connected to a backside metal 185. The second surface 101B of the first semiconductor substrate 101 may have the non-planarized surface in which the peripheral region around the conductive through-via 150 curves downward toward a backside metal thereby forming a dishing portion. The protruding portion 150P of the conductive penetration via 150 and a non-planarized portion (or a dishing portion) S of the first semiconductor substrate 101 may be generated by a difference in a selection ratio between a conductive material 155 (e.g., tungsten (W)) of the conductive through-via 150 and the first semiconductor substrate 101 (e.g., silicon (Si)) in a thinning process (see FIG. 9D) such as a chemical mechanical polishing (CMP) for exposing the conductive through-via. For example, the first semiconductor substrate 101 adopted in this example embodiment may have a thickness of 2 µm or less.

During the thinning process of the first semiconductor substrate 101, the second surface 101B of the first semiconductor substrate 101 may be recessed in a different region other than the peripheral region around the conductive through-via 150. As illustrated in FIG. 3, the peripheral region may have a dishing portion S that is gradually recessed to a greater depth as the distance from the conductive through-via 150 increases. In this manner, various types non-planarized structures may occur due to the difference in an etch selectivity.

In some embodiments, the lower surface of the planarized insulating layer is flat and an upper surface of the planarized insulating layer is flat with the exception of the dishing portion near the peripheral region (see the dishing portion S in FIG. 3). Also, in some embodiments, the conductive through-via 150 penetrates in the peripheral region through the second surface of the first semiconductor substrate 101.

In order to improve such a non-planarized structure, the planarized insulating layer 191 may be formed over the second surface 101B of the first semiconductor substrate 101. In this example embodiment, the planarized insulating layer 191 may have a planarized upper surface on substantially the same level as the contact region of the conductive through-via 150 while surrounding the protruding portion 150P of the conductive through-via 150.

A maximum thickness t of the planarized insulating layer 191 may be defined by a difference between a contact region level of the conductive through-via 150 and a lowest level of the second surface 101B of the first semiconductor substrate 101. For example, the maximum thickness t of the planarized insulating layer 191 may range from 2 nm to 15 nm.

The backside wiring structure 180 may be disposed on the planarized insulating layer 191. The backside wiring structure 180 may include a backside insulating layer 181 on the planarized insulating layer 191 and a backside metal 185 disposed in the backside insulating layer 181 and connected to the conductive through-via 150. The backside metal 185 may be formed in the backside insulating layer 181 using a damascene process. The backside metal 185 may include a conductive material 185A and a conductive barrier 185B disposed on a side surface and a lower surface of the conductive material 185A, respectively. For example, the conductive material 185Amay include Cu, Co, Mo, Ru, W, or alloys thereof, and the conductive barrier 185B may include Ta, TaN, Mn, MnN, WN, Ti, TiN, or combinations thereof. In an example embodiment of the present disclosure, the backside metal 185 is exemplified as a bonding pad, but in another example embodiment, the backside metal 185 may have a wiring layer structure similar to a first wiring layer 175, and in the instant case, the backside insulating layer 181 may be provided as a plurality of insulating layers.

In an example embodiment of the present disclosure, an etch stop layer 192 may be disposed between the planarized insulating layer 191 and the backside insulating layer 181. The etch stop layer 192 may be used in a process (e.g., a damascene process) of forming the backside metal 185.

For example, the planarized insulating layer 191 may include SiO₂, SiN, SiCN, SiC, SiCOH, or SiON. Furthermore, the etch stop layer 192 may include a compound containing aluminum. For example, the etch stop layer 192 may include Al₂O₃ or AlN. The backside insulating layer 181 may include SiO₂, SiN, SiCN, SiC, SiCOH, or SiON, and in some example embodiments, the backside insulating layer 181 may include SiO₂.

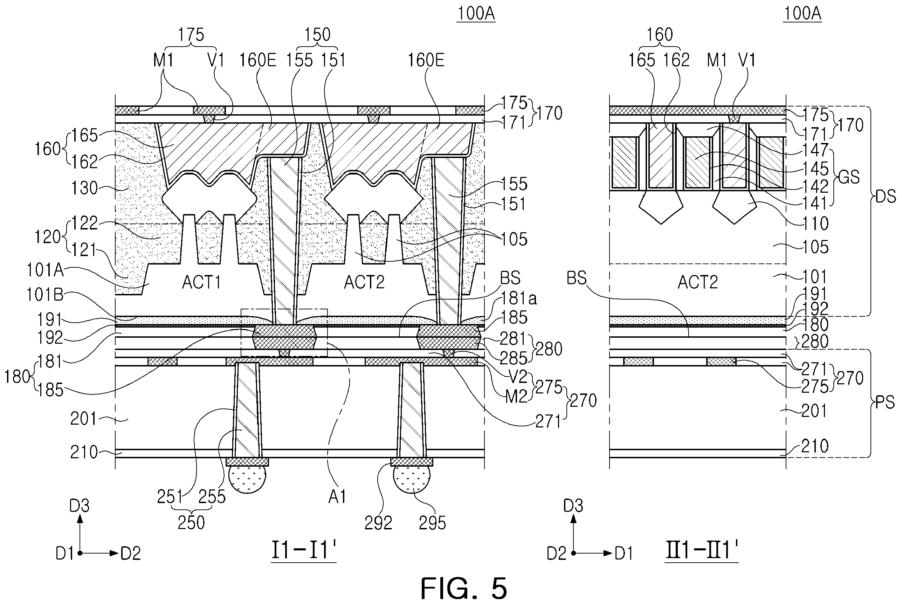

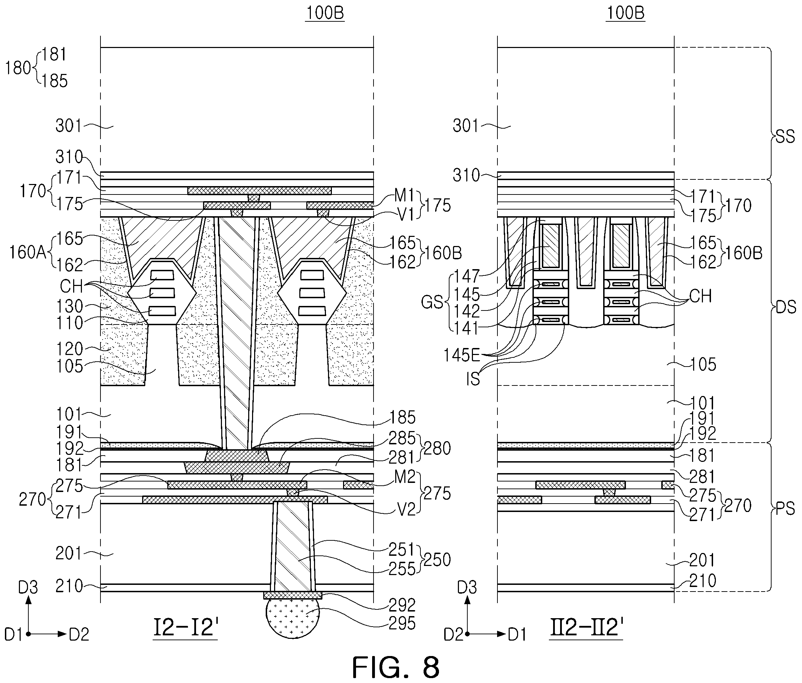

The conductive through-via 150 adopted in an example embodiment of the present disclosure may be provided as a path for supplying power for driving the device structure DS, that is, devices implemented on the first surface 101A of the first semiconductor substrate 101. In some example embodiments, the semiconductor device 100 may include a power supply structure PS electrically connected to the device structure DS and configured to supply power from an external circuit to the device structure DS (specifically, the active pattern 105) (see FIGS. 5 and 8).

The planarization structure of the second surface 101B of the first semiconductor substrate 101 and the backside metal 185 used as a power supply path may be modified and implemented in various forms. Various modified examples are illustrated in FIGS. 4A and 4B, and may be understood as a partial enlarged view of the semiconductor device corresponding to FIG. 3, respectively.

Referring to FIG. 4A, the semiconductor device according to an example embodiment of the present disclosure has a structure similar to that illustrated in FIG. 3, except that a protruding portion 150P' of the conductive through-via 150 is relatively large and a dishing portion S' is slightly small in a peripheral region around the conductive through-via 150. Furthermore, the components of this example embodiment may be understood by referring to the description of the same or similar components of the semiconductor device 100 illustrated in FIGS. 1 to 3, unless indicated otherwise.

Similarly to the previous example embodiment, by a substrate thinning process such as a CMP, the conductive through-via 150 may have the protruding portion 150P' protruding from the second surface 101B of the first semiconductor substrate 101, but the second surface 101B of the first semiconductor substrate 101 may have a different shape from the previous example embodiment. Specifically, the protruding portion 150P' of the conductive through-via 150 may be relatively large, and the height of the protruding portion 150P' may be, for example, 5 nm or more. Meanwhile, the dishing portion S' may be slightly small in the peripheral region around the conductive through-via 150, and in some example embodiments, the dishing portion S' may have an almost planarized surface.

Referring to FIG. 4B, it may be understood that the semiconductor device according to an example embodiment of the present disclosure has a structure similar to that illustrated in FIG. 3, except that there is little protruding portion of the conductive through-via 150 and no etch stop layer is adopted. Furthermore, the components of an example embodiment of the present disclosure may be understood by referring to the description of the same or similar components of the semiconductor device 100 illustrated in FIGS. 1 to 3, unless indicated otherwise.

In an example embodiment of the present disclosure, the conductive through-via 150 rarely protrudes from the second surface 101B of the first semiconductor substrate 101, but the peripheral region of the second surface 101B may have a relatively large dishing region S". In an example embodiment of the present disclosure, the etch stop layer may be not introduced, and the backside wiring structure 180 may be directly formed on the planarized insulating layer 191. In some embodiments, an etch stop layer 192 is interposed. Specifically, the backside insulating layer 181 may be directly disposed on the planarized insulating layer 191, and the backside metal 185 connected to the conductive through-via 150 from the backside insulating layer 181 may be partially connected to the planarized insulating layer 191.

FIG. 5 is a cross-sectional view illustrating a semiconductor device according to an example embodiment of the present disclosure.

Referring to FIG. 5, it may be understood that a semiconductor device 100A according to an example embodiment of the present disclosure has a structure similar to the semiconductor device 100 illustrated in FIGS. 1 to 3, except that the semiconductor device 100A includes a power supply structure PS having a second semiconductor substrate 201 instead of the support structure. Furthermore, the components of an example embodiment of the present disclosure may be understood by referring to the description of the same or similar components of the semiconductor device 100 illustrated in FIGS. 1 to 3, unless indicated otherwise.

The semiconductor device 100A according to an example embodiment of the present disclosure includes a device structure DS having the first semiconductor substrate 101, and a power supply structure PS disposed on a lower surface of the device structure DS and having the second semiconductor substrate 201. The semiconductor device 100A may further include a first bonding structure 180 and a second bonding structure 280 for electrical/mechanical bonding between the device structure DS and the power supply structure PS.

The device structure DS according to an example embodiment of the present disclosure includes a conductive through-via 150 penetrating through the interlayer insulating film 130 and the device isolation film 120 and the first semiconductor substrate 101. Similarly to the previous example embodiment, the conductive through-via 150 may be formed in a substrate region between the first and second active regions ACT1 and ACT2, and may be formed from the interlayer insulating film 130 before forming the front wiring structure 170. The conductive through-via 150 may have a narrower width as it approaches the second surface 101B of the first semiconductor substrate 101.

Unlike the previous example embodiment, the conductive through-via 150 adopted in an example embodiment of the present disclosure may be directly connected to the contact structure 160. The contact structure 160 may be formed before forming the front wiring structure 170, similarly to the conductive through-via 150. Specifically, after forming the conductive through-via 150, the contact structure 160 may be formed.

The contact structure 160 adopted in an example embodiment of the present disclosure has an extension portion 160E extending in the second direction (e.g., D2) in the interlayer insulating film 130 and connected to an upper end of the conductive through-via 150.

The conductive through-via 150 adopted in an example embodiment of the present disclosure may be provided as a path for supplying power required for the device structure DS, that is, devices implemented on the first surface 101A of the first semiconductor substrate 101. The semiconductor device 100A according to an example embodiment of the present disclosure may include a power supply structure PS electrically connected to the device structure DS and configured to supply power from the external circuit to the device structure DS (specifically, the active pattern 105).

In an example embodiment of the present disclosure, the first bonding structure 180 and the second bonding structure 280 may be formed on opposite sides on which the device structure DS and the power supply structure PS face each other, respectively. Specifically, the second surface of the first semiconductor substrate on which the first bonding structure is formed may have a planarization structure similar to that of the previous example embodiment. Hereinafter, it will be described in detail with reference to FIG. 6.

FIG. 6 is an enlarged cross-sectional view illustrating part "A1" of the semiconductor device illustrated in FIG. 5.

Referring to FIG. 6, a planarization structure is introduced on one side of the device structure DS, that is, between the second surface 101B of the first semiconductor substrate 101 and the first bonding structure 180.

The conductive through-via 150 may have a portion protruding from the second surface 101B of the first semiconductor substrate 101. Furthermore, the second surface 101B of the first semiconductor substrate 101 may have a non-planarized surface in which the peripheral region around the conductive through-via 150 curves downward toward a backside metal 185 thereby forming a dishing portion. The planarized insulating layer 191 may be formed on the second surface 101B of the first semiconductor substrate 101 to surround the protruding portion 150P of the conductive through-via 150. The planarized insulating layer 191 may have a planarized upper surface on substantially the same level as the contact region of the conductive through-via 150. Furthermore, the etch stop layer 192 may be disposed on the planarized insulating layer 191.

The first bonding structure 180 may be disposed on the etch stop layer 192. The first bonding structure 180 may include a first bonding insulating layer 181 on the planarized insulating layer 191 and a first bonding pad 185 buried in the first bonding insulating layer 181 and connected to the conductive through-via 150. The first bonding pad 185 may be formed in the first bonding insulating layer 181 using the etch stop layer 192.

The second bonding structure 280 provided in one side of the power supply structure PS may be bonded to the first bonding structure 180. The second bonding structure 280 has a second bonding insulating layer 281 bonded to the first bonding insulating layer 181, and a second bonding pad 285 buried in the second bonding insulating layer 281 and bonded to the first bonding pad 185. The second bonding pad 285 may have a surface substantially coplanar with a surface of the second bonding insulating layer 281, similarly to the first bonding structure 180. In this manner, the surfaces to be bonded of the first and second bonding structures 180 and 280 may be formed to be sufficiently clean and planarized, thereby ensuring solid bonding without generating voids at a bonding interface.

The first and second bonding pads 185 and 285 may be formed in the first and second bonding insulating layers 181 and 281, respectively, using the damascene process. The first and second bonding pads 185 and 285 may have surfaces substantially coplanar with surfaces of the first and second bonding insulating layers 181 and 281, respectively. The first and second bonding pads 185 and 285 may include conductive materials 185A and 285A and conductive barriers 185B and 285B disposed on side surfaces and lower surfaces of the conductive materials 185A and 285A, respectively. For example, the conductive materials 185Aand 285A may include Cu, Co, Mo, Ru, W, or alloys thereof. For example, the conductive barriers 185B and 285B may include Ta, TaN, Mn, MnN, WN, Ti, TiN, or combinations thereof.

Using the first and second bonding structures 180 and 280, the device structure DS may be hybrid-bonded to the power supply structure PS so as to mutually form an electrical connection path.

Specifically, the first bonding pad 185 and the second bonding pad 285 may include the same metal, for example, copper (Cu). The first and second bonding pads 185 and 285 directly bonded may be combined by mutual diffusion of copper through a high-temperature annealing process (see 'BS1'). A metal constituting the first and second bonding pads 185 and 285 are not limited to copper, and may include other metal materials (e.g., Au) that may be similarly bonded to each other. In an intermetallic bonding BS1, an electrical connection may be achieved together with solid bonding.

The first bonding insulating layer 181 and the second bonding insulating layer 281 may include the same dielectric material, for example, silicon oxide. Direct bonding of the first and second bonding insulating layers 181 and 281 may be performed by applying a high-temperature annealing process in a state where the two bonding insulating layers 181 and 281 are in direct contact with each other. An interdielectric bonding BS2 may be firmly implemented as rigid bonding through covalent coupling. In some example embodiments, interface layers of the first and second bonding insulating layers 181 and 281 may include other insulating materials. For example, the first and second bonding insulating layers 181 and 281 include silicon oxide, and on a surface to be bonded to the first and second bonding insulating layers 181 and 281, other insulating films such as SiCN, SiON, or SiCO, which are substantially coplanar with the first and second bonding pads 185 and 285, respectively, may be provided as thin films to form a bonding layer.

In this manner, without forming a separate power supply network element (e.g., buried power rail) in the first semiconductor substrate 101 of the device structure DS, after forming the conductive through-via 150, the power supply structure PS may be bonded with a hybrid bonding technology using the first and second bonding structures 180 and 280, and accordingly, in a process of forming a conductive element for a separate power supply network in the first semiconductor substrate 101, a desired power supply network may be implemented by minimizing defects.

The power supply structure PS adopted in an example embodiment of the present disclosure may include a second wiring structure 270 disposed on the second bonding structure 280 and a second semiconductor substrate 201 having a contact via 250 connected to the second wiring structure 270. The second wiring structure 270 includes a second insulating layer 271 and a second wiring layer 275. The second wiring layer 275 includes a second metal line M2 and a second metal via V2, and may be configured to connect the contact via 250 and the second bonding pad 285. For example, the second wiring layer 275 may be formed using the dual damascene process. In an example embodiment of the present disclosure, the second wiring layer 275 is illustrated as a single layer structure, but in some example embodiments, the second wiring layer 275 may be implemented as a multilayer structure.

The contact via 250 may be formed in the second semiconductor substrate 201 to receive power from an external circuit. In an example embodiment of the present disclosure, the contact via 250 may penetrate through the second semiconductor substrate 201 and be connected to the second wiring layer 275 (e.g., a landing pad), a protective insulating film 210 may be formed below a lower surface of the second semiconductor substrate 201, and an external bonding pad 292 connected to the contact via 250 and an electrical connecting conductor 295 such as a solder ball for connection with an external circuit may be provided.

The contact via 250 may include a conductive material 255, and an insulating barrier 251 surrounding a side surface of the conductive material 255 to be electrically insulated from the second semiconductor substrate 201, similarly to the conductive through-via 150. Contrary to a formation direction of the conductive through-via 150, the contact via 250 may have a narrower width as it approaches to the second wiring structure 270.

In an example embodiment of the present disclosure, the second semiconductor substrate 201 may be provided as a different substrate structure other than the power supply structure PS for power supply. For example, the second semiconductor substrate 201 may be a semiconductor substrate on which a logic and/or a memory element (not illustrated) is implemented. Similarly to the previous example embodiment, the second semiconductor substrate 201 includes the second wiring structure 270 and the second bonding structure 280, and may be bonded to the device structure DS similarly to the semiconductor device illustrated in FIG. 5. In some example embodiments, the second semiconductor substrate 201 may be a substrate in which the logic and/or the memory element is implemented along with power supply structures similar to those of the previous example embodiment.

FIG. 7 is a plan view illustrating a semiconductor device according to an example embodiment of the present disclosure, and FIG. 8 is cross-sectional views of the semiconductor device illustrated in FIG. 7 taken along lines I2-I2' and II2-II2'.

Referring to FIGS. 7 and 8, a semiconductor device 100B according to an example embodiment of the present disclosure may be understood as having a structure similar to that of the semiconductor device 100 illustrated in FIGS. 1 to 3, except that the semiconductor device 100B has a multichannel structure equipped with a plurality of channel layers CH on each of the active patterns 105 and further includes a support structure SS disposed on the device structure DS, and a first wiring structure 170 and a second wiring structure 270 are implemented as a plurality of wiring layers. Item 150' refers to the conductive through-via in FIG. 7. Furthermore, the components of an example embodiment of the present disclosure can be understood by referring to the description of the same or similar components of the semiconductor device 100 illustrated in FIGS. 1 to 3, unless described otherwise.

The semiconductor device 100B according to an example embodiment of the present disclosure may have a transistor (i.e., MBCFET^{®}) structure having a plurality of channel layers formed of nanosheets. The semiconductor device 100B may further include a plurality of nanosheet channel layers CH spaced apart from each other in a third direction (e.g., D3) on each of the active patterns 105, and internal spacer layers IS disposed parallel to the gate electrode 145 between the plurality of channel layers CH. The semiconductor device 100B may include transistors with a gate-all-around structure in which a portion 145E of the gate electrode 145 is disposed between the active pattern 105 and lowest channel layers CH and between the plurality of channel layers CH. For example, each transistor of the semiconductor device 100B may made up of the channel layers CH, the source/drain regions 110 and the gate electrode 145.

The plurality of channel layers CH may be disposed on the active pattern 105 and two or more channel layers CH may be spaced apart from each other in the third direction (e.g., D3). The channel layers CH may be connected to the source/drain regions 110 and may be spaced apart from upper surfaces of the active pattern 105. The channel layers CH may have a width the same as or similar to that of the active pattern 105 in the second direction (e.g., D2), and may have a width the same as or similar to that of the gate structure GS in the first direction (e.g., D1). However, as in an example embodiment of the present disclosure, if an internal spacer IS is adopted, the channel layers CH may have a width wider than a width of side surfaces at a lower portion of the gate structure GS.

The plurality of channel layers CH may be formed of a semiconductor material, and may include at least one of silicon (Si), silicon germanium (SiGe), and germanium (Ge). The channel layers CH may be formed of, for example, the same material as the first semiconductor substrate 101 (specifically, the active region). The number and shape of the channel layers CH constituting one channel structure may be variously modified in example embodiments.

The internal spacers IS may be disposed on opposite sides of the gate electrode 145 in the first direction (e.g., D1) between the plurality of channel layers CH. The gate electrode 145 may be electrically spaced apart from source/drain regions 110 by the internal spacers IS. The internal spacers IS may have a planarized side facing the gate electrode 145 or a cross-section that is convexly rounded toward the gate electrode 145 (see FIG. 8). The internal spacers IS may be formed of an oxide, a nitride, or an oxynitride, and in particular, may be formed of a low dielectric constant film.

In this manner, the semiconductor device 100B according to an example embodiment of the present disclosure may be applied to transistors having various structures, and may be implemented as a semiconductor device including a vertical FET (VFET) having an active region extending perpendicular to an upper surface of the first semiconductor substrate 101 and a gate structure surrounding the active region, or a semiconductor device including a negative capacitance FET (NCFET) using a gate insulating film with ferroelectric properties, in addition to the above-described example embodiments.

In an example embodiment of the present disclosure, a support structure SS may be further disposed on the device structure DS. The support structure SS may be bonded to the first wiring structure 170 before a grinding process of the first semiconductor substrate 101, and may remain in a final structure. The support structure SS includes a support substrate 301 and a bonding insulating layer 310 disposed on an upper surface of the support substrate 301. For example, the bonding insulating layer 310 may include SiO₂, SiCN, SiON, or SiCO, or may include a bonding material layer. The bonding insulating layer 310 of the support structure SS may be directly bonded to a first insulating layer 171 of the first wiring structure 170. In another example embodiment, the support substrate 301, such as a silicon substrate, may be directly bonded to the device structure DS using a planarized surface. Such a process may be performed by a wafer-to-wafer process.

Similarly to the example embodiment illustrated in FIGS. 7 and 8, a planarization structure is introduced on one side of the device structure DS, that is, between the second surface 101B of the first semiconductor substrate 101 and the first bonding structure 180.

The conductive through-via 150' may have a portion protruding from the second surface 101B of the first semiconductor substrate 101. Unlike the previous example embodiment, the conductive through-via 150' adopted in an example embodiment of the present disclosure may have a rail structure extending in a certain direction (e.g., the second direction) (see FIG. 7).

Furthermore, the second surface 101B of the first semiconductor substrate 101 may have the non-planarized surface in which the peripheral region around the conductive through-via 150' curves downward toward a backside metal thereby forming a dishing portion (see, for example, FIG. 2, FIG. 3, FIG. 4A, FIG. 4B, FIG. 5, FIG. 6 or FIG. 8). The planarized insulating layer 191 may be formed on the second surface 101B of the first semiconductor substrate 101 to surround the protruding portion 150P of the conductive through-via 150'. The planarized insulating layer 191 may have a planarized upper surface on substantially the same level as the contact region of the conductive through-via 150'.

Furthermore, the etch stop layer 192 may be disposed on the planarized insulating layer 191. The first bonding structure 180 may be disposed on the etch stop layer 192. The first bonding structure 180 may include a first bonding insulating layer 181 on the planarized insulating layer 191 and a first bonding pad 185 buried in the first bonding insulating layer 181 and connected to the conductive through-via 150'.

The second bonding structure 280 provided in one side of the power supply structure PS may be bonded to the first bonding structure 180. The second bonding structure 280 includes the second bonding insulating layer 281 bonded to the first bonding insulating layer 181, and a second bonding pad 285 buried in the second bonding insulating layer 281 and bonded to the first bonding pad 185. The second bonding pad 285 may have a surface substantially coplanar with a surface of the second bonding insulating layer 281, similarly to the first bonding structure 180. The first and second bonding pads 185 and 285 may have surfaces substantially planar with respect to surfaces of the first and second bonding insulating layers 181 and 281.

The first and second bonding structures 180 and 280 may be firmly bonded to each other by the intermetallic bonding BS1 of the first and second bonding pads 185 and 285 and the interdielectric bonding BS2 of the first and second bonding insulating layers 181 and 281.

The first wiring structure 170 disposed on the interlayer insulating film 130 and the second wiring structure 270 disposed on the second semiconductor substrate 201 may include two wiring layers 175 and 275, respectively. However, in other example embodiments, the first wiring structure 170 and the second wiring structure 270 may be implemented as a different number of layers.

The power supply structure PS adopted in an example embodiment of the present disclosure may include the second semiconductor substrate 201 and a contact via 250 connected to the second wiring layer 275 of the second wiring structure 270 through the second semiconductor substrate 201. Furthermore, similarly to the previous example embodiment, the protective insulating film 210 may be formed on the lower surface of the second semiconductor substrate 201, and the external bonding pad 292 connected to the contact via 250 and the electrical connecting conductor 295 such as a solder ball for connection with an external circuit may be provided.

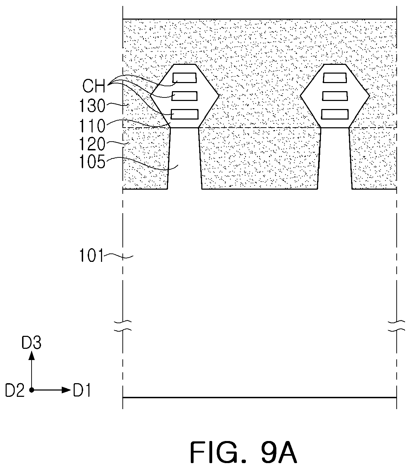

FIGS. 9A to 9H are cross-sectional views for each main process for describing some processes (e.g., device structure manufacturing processes) of a method of manufacturing the semiconductor device illustrated in FIG. 8.

Referring to FIG. 9A, a semiconductor element may be formed on the first surface 101A of the first semiconductor substrate 101.

Specifically, a plurality of channel layers CH are formed on the upper surface of each of a plurality of active patterns 105, source/drain regions 110 connected to both ends of the plurality of channel layers CH are formed on the active patterns 105, and an interlayer insulating film 130 is formed on the device isolation film 120 to cover the source/drain regions 110. As illustrated in FIG. 8, the gate structure GS may be formed using a dummy gate structure (not illustrated).

In an example embodiment of the present disclosure, a conductive through-via is formed in a process of forming the contact structure instead of directly forming a conductor element (e.g., an embedded power rail (BPN)) for forming a power supply network in the first semiconductor substrate.

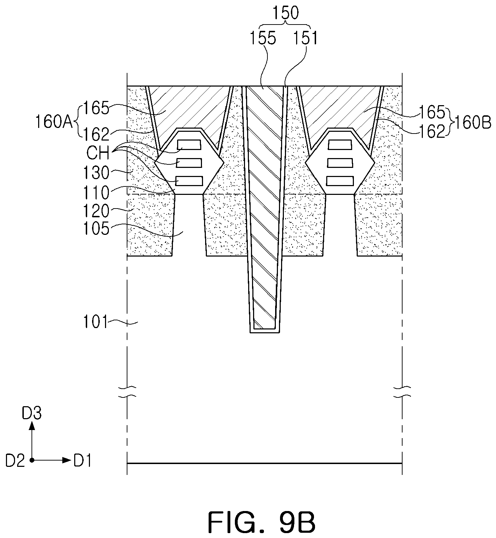

Next, referring to FIG. 9B, a conductive through-via 150 and a contact structure 160 may be formed.

The conductive through-via 150 may be formed in a process of forming a through-hole to a desired depth, forming an insulating barrier 151 on an internal surface of the through-hole, and then charging a conductive material 155 in the through-hole. Through a planarization process such as chemical mechanical polishing (CMP), the insulating barrier 151 and the conductive material 155 on the interlayer insulating film 130 may be removed. The conductive through-via 150 may be formed to extend to some regions of the first semiconductor substrate 101 by penetrating through the interlayer insulating film 130 and the device isolation film 120. The conductive through-via 150 may be formed to have a relatively high aspect ratio.

Similarly thereto, the contact structure 160 may be formed in a process of forming a contact hole up to the source/drain regions 110, forming a conductive barrier 162 on an internal surface of the contact hole, and then charging a conductive material 165 in to the contact hole. Furthermore, the conductive barrier 162 and the conductive material 165 on the interlayer insulating film 130 can be removed through a planarization process such as a CMP.

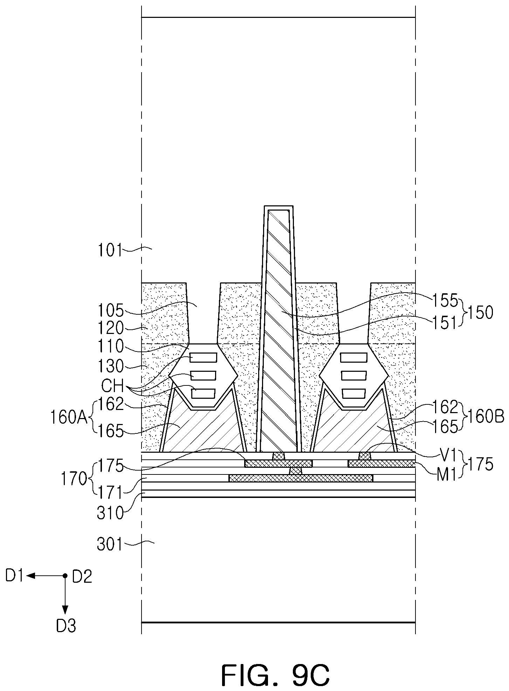

In this manner, before forming the first wiring structure 170 (see FIG. 9C), which is a BEOL, the conductive through-via 150 may be formed together with the contact structure 160.

Then, referring to FIG. 9C, the first wiring structure 170 may be formed and then bonded to the support substrate 301 on the device structure DS.

The first wiring structure 170 connected to the contact structure 160 is formed on the interlayer insulating film 130. An etching stop film (not illustrated) may be formed on the interlayer insulating film 130, and a plurality of first insulating layers 171 and a first wiring layer 175 including a first metal line M1 and a first metal via V1 may be formed. The first metal line M1 and the first metal via V1 may be formed together by using the dual damascene process.

The support substrate 301 may be bonded to the first wiring structure 170 using a bonding insulating layer 310. For example, the bonding insulating layer 310 may include SiO₂, SiCN, SiON or SiCO. The bonding insulating layer 310 may be directly bonded to the first insulating layer 171 of the first wiring structure 170. Such a process may be performed by a wafer-to-wafer process. The support substrate 301 may be used as a support structure during a grinding process of the first semiconductor substrate 101. In other example embodiments, the support substrate 301, such as a silicon substrate, may be directly bonded to the device structure DS using a planarized surface.

Then, referring to FIG. 9D, a polishing process of reducing the thickness of the first semiconductor substrate 101 may be performed using the support substrate 301.

The polishing process may be performed by a CMP process on the second surface 101B of the first semiconductor substrate 101. Through the present process, the first semiconductor substrate 101 may be reduced to a desired thickness. The thickness of the first semiconductor substrate 101 may be 1 µm or less. After the present process, the first semiconductor substrate 101 may have a protruding portion 150P of the conductive through-via 150 protruding from the second surface 101B thereof. The peripheral region around the protruding portion 150P protruding from the second surface 101B of the first semiconductor substrate 101 may have a non-planarized element such as a recessed region or a dishing portion, and the second surface 101B of the first semiconductor substrate 101 after the CMP process may be non-planarized due to the protruding portion 150P with the non-planarized element. A difference d between an upper surface of the protruding portion 150P of the conductive through-via 150, that is, the contact region level, and a lowest level of the second surface 101B of the first semiconductor substrate 101 may range from 2 nm to 15 nm.

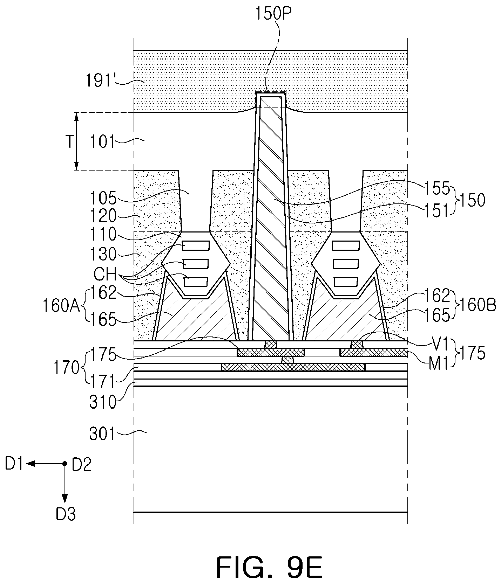

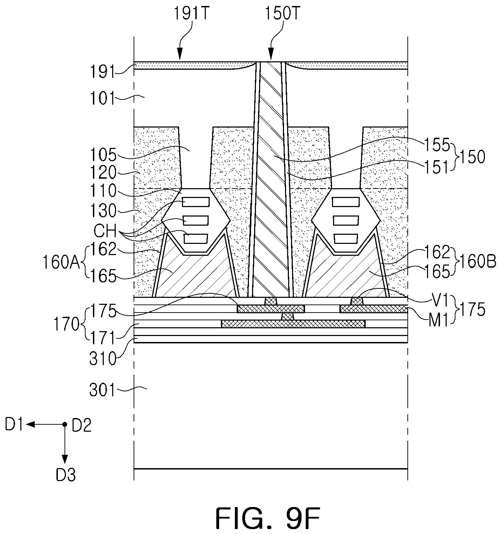

Next, referring to FIG. 9E, a planarized insulating layer 191' covering the protruding portion 150P of the conductive through-via 150 is formed on the first semiconductor substrate 101. Then, referring to FIG. 9F, the protruding portion 150P of the conductive through-via 150 and the planarized insulating layer 191' may be planarized.

This planarization process may also be performed by the CMP process or an etch-back process. After this planarization process, the conductive through-via 150 has a surface 150T substantially coplanar with a surface 191T of the planarized insulating layer 191. Furthermore, the insulating barrier 151 may be removed from the surface 150T of the conductive through-via 150, thus exposing the conductive material 155 and providing a contact region. The planarized surface may be directly used as a bonding surface.

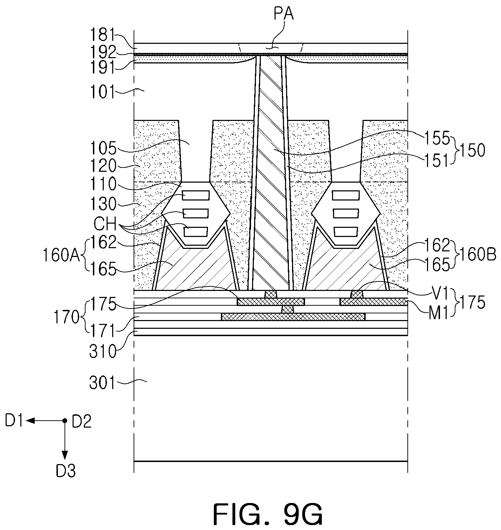

Next, referring to FIG. 9G, an etch stop layer 192 and a first bonding insulating layer 181 may be sequentially formed on the planarized surfaces 150T and 191T obtained in the previous process.

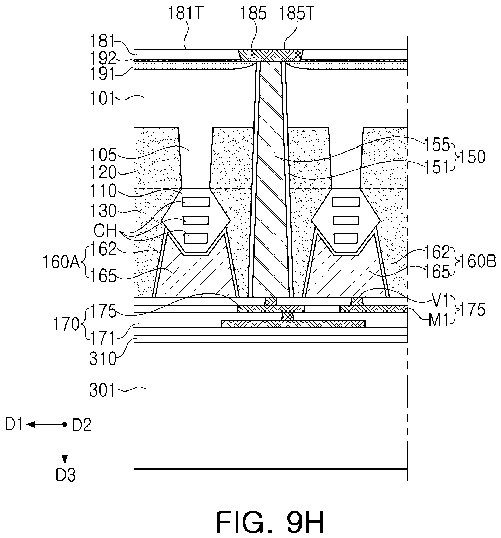

The etch stop layer 192 may be used in a first bonding pad forming process. In an etching process of forming an opening PA for a first bonding pad 185 (see FIG. 9H) in the first bonding insulating layer 181, an etching depth may be adjusted by protecting the lower structures using the etch stop layer 192. For example, the first bonding insulating layer 181 may include SiO₂, SiN, SiCN, SiC, SiCOH, or SiON, and the etch stop layer 192 may include Al₂O₃ or AlN.

Then, as illustrated in FIG. 9H, the first bonding pad 185 connected to the conductive through-via 150 may be formed in the opening PA of the first bonding insulating layer 181.

The first bonding pad 185 may be formed using the damascene process. In the planarization process introduced into this damascene process, a surface 181T of the first bonding insulating layer 181 may be substantially coplanar with a surface 185T of the first bonding pad 185.

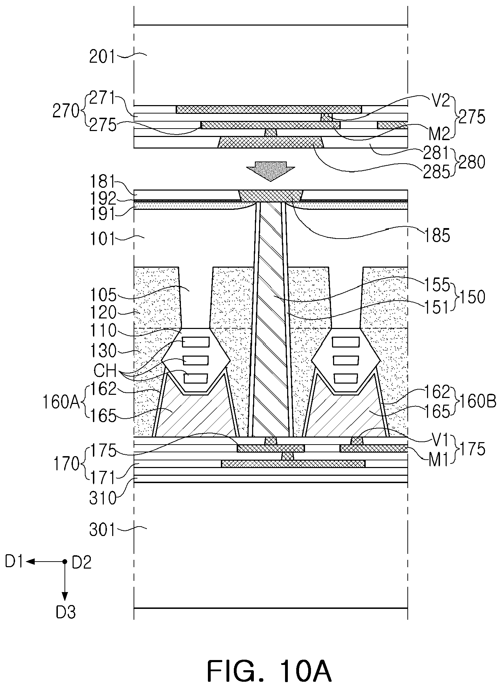

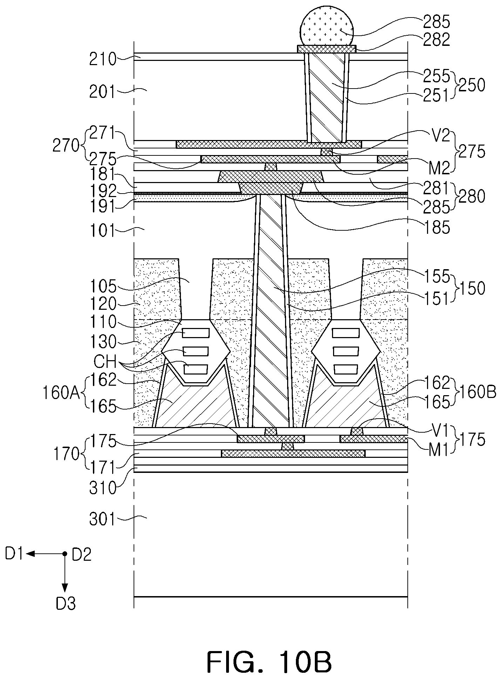

FIGS. 10A and 10B are cross-sectional views for each main process for explaining some other processes (e.g., bonding processes) of the method of manufacturing the semiconductor device illustrated in FIG. 8.

Referring to FIG. 10A, a power supply structure PS having a second bonding structure 280 may be formed and then the second bonding structure 280 may be bonded to the first bonding structure 180.

The power supply structure PS includes a second semiconductor substrate 201, a second wiring structure 270 disposed on the second semiconductor substrate 201, and a second bonding structure 280 disposed on the second wiring structure 270. The second bonding structure 280 may be disposed on and bonded to the first bonding structure 180. The second bonding structure 280 includes a second bonding insulating layer 281 bonded to the first bonding insulating layer 181, and a second bonding pad 285 buried in the second bonding insulating layer 281 and bonded to the first bonding pad 185. The second bonding pad 285 may have a surface substantially coplanar with a surface of the second bonding insulating layer 281. The first bonding pad 185 and the second bonding pad 285 may be provided in a solid bonding structure along with an electrical path for the device structure DS and the power supply structure PS.

Then, referring to FIG. 10B, the second semiconductor substrate 201 is processed to form a power supply structure PS having structures 250, 292 and 295 that can be connected to an external circuit.

First, a contact via 250 penetrating through the second semiconductor substrate 201 may be formed to receive power from the external circuit. In an example embodiment of the present disclosure, the contact via 250 may penetrate through the second semiconductor substrate 201 and be connected to a partial region (e.g., a landing pad) of the second wiring layer 275. Furthermore, a protective insulating film 210 is formed on the lower surface of the second semiconductor substrate 201, and a bonding pad 292 connected to the contact via 250 and an electrical connecting conductor 295 such as a solder ball for connection with the external circuit may be provided.

In this manner, the electric paths (e.g., the first and second bonding pads) formed by hybrid bonding with the conductive through-via 150 of the first semiconductor substrate 101 may be used to supply power to the device structure DS using an additional power supply structure PS.

The present disclosure is not limited to the embodiment described above and the accompanying drawings. The scope of rights of the present disclosure is intended to be limited by the appended claims. Therefore, those of ordinary skill in the art may make various replacements, modifications, or changes without departing from the scope of the present disclosure defined by the appended claims, and these replacements, modifications, or changes should be construed as being included in the scope of the present disclosure. Embodiments of the invention also encompass the following numbered clauses:
Clause 1. A semiconductor device comprising: a first semiconductor substrate having a first surface and a second surface disposed opposite to each other and having an active pattern extending on the first surface in a first direction; a gate structure disposed in one region of the active pattern and extending in a second direction intersecting the first direction; a source/drain region disposed in the active pattern on a side of the gate structure; an interlayer insulating film disposed on the first semiconductor substrate and covering the source/drain region; a contact structure penetrating through the interlayer insulating film and connected to the source/drain region; a front wiring structure having a front insulating layer disposed on the interlayer insulating film and a front wiring layer disposed in the front insulating layer and electrically connected to the contact structure; a conductive through-via electrically connected to the contact structure or the front wiring layer and penetrating through the interlayer insulating film and the first semiconductor substrate, wherein the second surface of the first semiconductor substrate has a non-planarized surface in which a region around the conductive through-via is higher than other regions; a planarized insulating layer disposed on the second surface of the first semiconductor substrate and having a planarized upper surface on substantially a same level as a bottom of the conductive through-via; and a backside wiring structure having a backside insulating layer disposed on the planarized insulating layer and a backside metal disposed in the backside insulating layer and connected to the bottom of the conductive through-via.
Clause 2. The semiconductor device of clause 1, wherein the conductive through-via has a portion protruding from the second surface of the first semiconductor substrate, and the planarized insulating layer surrounds the protruding portion.
Clause 3. The semiconductor device of clause 1 or 2, wherein a difference between the bottom of the conductive through-via and a lowest level of the second surface of the first semiconductor substrate ranges from 2 nm to 15 nm.
Clause 4. The semiconductor device of clause 1, 2 or 3, wherein the planarized insulating layer includes SiO₂, SiN, SiCN, SiC, SiCOH, or SiON.
Clause 5. The semiconductor device of any one preceding clause, further comprising: an etch stop layer disposed between the planarized insulating layer and the backside insulating layer.
Clause 6. The semiconductor device of clause 5, wherein the etch stop layer includes a compound containing aluminum.
Clause 7. The semiconductor device of any one preceding clause, wherein the contact structure has a portion extending in the second direction and connected to the conductive through-via.
Clause 8. The semiconductor device of any one preceding clause, wherein the front wiring layer has a metal via connected to the conductive through-via.
Clause 9. The semiconductor device of any one preceding clause, wherein the first semiconductor substrate has a thickness of 2 µm or less.
Clause 10. The semiconductor device of any one preceding clause, wherein the backside wiring structure further includes a first bonding pad having a surface substantially coplanar with a surface of the backside insulating layer.
Clause 11. The semiconductor device of clause 10, further comprising: a bonding structure disposed on the backside wiring structure, and having a bonding insulating layer bonded to the backside insulating layer and a second bonding pad embedded in the bonding insulating layer and bonded to the first bonding pad; a lower wiring structure disposed on the bonding structure and having a lower wiring layer connected to the second bonding pad; and a second semiconductor substrate disposed on the lower wiring structure.
Clause 12. The semiconductor device of clause 11, wherein the second semiconductor substrate includes a contact via penetrating through the second semiconductor substrate and connected to the lower wiring layer.
Clause 13. The semiconductor device of clause 11, or 12 wherein the second semiconductor substrate includes a logic device or a memory device.
Clause 14. The semiconductor device of any one preceding clause, further comprising: a support substrate disposed on the front wiring structure.
Clause 15. The semiconductor device of any one preceding clause, further comprising: a plurality of channel layers stack on the active pattern in a third direction perpendicular to the first and second directions, and spaced apart from each other, wherein the gate structure includes a gate electrode surrounding the plurality of channel layers, and a gate insulating film disposed between the plurality of channel layers and the gate electrode.
Clause 16. A semiconductor layer comprising: a first semiconductor substrate having a first surface and a second surface disposed opposite to each other and having an active pattern extending on the first surface in a first direction; a gate structure disposed in a portion of the active pattern and extending in a second direction intersecting the first direction; a source/drain region disposed in the active pattern on a side of the gate structure; an interlayer insulating film disposed on the first semiconductor substrate and covering the source/drain region; a contact structure penetrating through the interlayer insulating film and connected to the source/drain region; a first wiring structure having a first insulating layer disposed on the interlayer insulating film and a first wiring layer disposed in the first insulating layer and electrically connected to the contact structure; a conductive through-via electrically connected to the first wiring layer and penetrating through the interlayer insulating film and the first semiconductor substrate, wherein the conductive through-via has a protruding portion protruding from the second surface of the first semiconductor substrate and the second surface of the first semiconductor substrate has a non-planarized surface in which a region around the protruding portion is higher than other regions; a planarized insulating layer disposed on the second surface of the first semiconductor substrate, and surrounding a protruding portion of the conductive through-via, the planarized insulating layer having a surface substantially coplanar with a contact region of the conductive through-via; a first bonding structure having a first bonding insulating layer disposed on the planarized insulating layer, and a first bonding pad embedded in the first bonding insulating layer and connected to the contact region of the conductive through-via; an etch stop layer disposed between the planarized insulating layer and the first bonding insulating layer and including a material different from the first bonding insulating layer; a second bonding structure disposed on the first bonding structure, and having a second bonding insulating layer bonded to the first bonding insulating layer and a second bonding pad embedded in the second bonding insulating layer and bonded to the first bonding pad; a second wiring structure disposed on the second bonding structure, and having a second wiring layer connected to the second bonding pad; and a second semiconductor substrate having a contact via disposed on the second wiring structure and electrically connected to the second wiring layer.
Clause 17. The semiconductor layer of clause 16, wherein the first and second bonding insulating layers include SiO₂, SiN, SiCN, SiC, SiCOH, or SiON, and the etch stop layer includes Al₂O₃ or AlN.
Clause 18. The semiconductor layer of clause 16 or 17, wherein a difference between a level of the contact region of the conductive through-via and a lowest level of the second surface of the first semiconductor substrate ranges from 2 nm to 15 nm.
Clause 19. The semiconductor layer of clause 16, 17, or 18, wherein the conductive through-via has a narrower width as it approaches the second surface of the first semiconductor substrate, and the contact via has a narrower width as it approaches the second bonding structure.
Clause 20. A semiconductor layer comprising: a device structure including a first semiconductor substrate having a first surface and a second surface disposed opposite to each other and having an active pattern extending from the first surface in first direction, an interlayer insulating film disposed on the active pattern, a first wiring layer disposed on the interlayer insulating film, and a conductive through-via electrically connected to the first wiring layer and penetrating through the interlayer insulating film and the first semiconductor substrate, wherein the second surface of the first semiconductor substrate has a non-planarized surface in which a region around the conductive through-via is higher than other regions; a first bonding structure including a planarized insulating layer disposed on the second surface of the first semiconductor substrate and having a planarized upper surface, a first bonding insulating layer disposed on an upper surface of the planarized insulating layer, and a first bonding pad embedded in the first bonding insulating layer and connected to the conductive through-via; a second bonding structure disposed on the first bonding structure, and including a second bonding insulating layer bonded to the first bonding insulating layer and a second bonding pad embedded in the second bonding insulating layer and bonded to the first bonding pad; a power supply structure including a second wiring layer disposed on the second bonding structure and a second semiconductor substrate with a contact via connected to the second wiring layer; and a support structure disposed on the first wiring layer of the device structure.

## Claims

1. A semiconductor device comprising:
a first semiconductor substrate having a first surface and a second surface disposed opposite to each other and having an active pattern extending on the first surface in a first direction;
a gate structure disposed in one region of the active pattern and extending in a second direction intersecting the first direction;
a source/drain region disposed in the active pattern on a side of the gate structure;
an interlayer insulating film disposed on the first semiconductor substrate and covering the source/drain region;
a contact structure penetrating through the interlayer insulating film and connected to the source/drain region;
a front wiring structure having a front insulating layer disposed on the interlayer insulating film and a front wiring layer disposed in the front insulating layer and electrically connected to the contact structure;
a conductive through-via electrically connected to the contact structure or the front wiring layer and penetrating through the interlayer insulating film and the first semiconductor substrate, wherein the second surface of the first semiconductor substrate has a non-planarized surface in a region around the conductive through-via, wherein the second surface curves downward thereby forming a dishing portion;
a planarized insulating layer disposed on the second surface of the first semiconductor substrate and having a lower surface on substantially a same level as a bottom of the conductive through-via; and
a backside wiring structure having a backside insulating layer disposed on the planarized insulating layer and a backside metal, wherein the backside metal is disposed in the backside insulating layer and connected to the bottom of the conductive through-via.

2. The semiconductor device of claim 1, wherein the conductive through-via has a first portion, wherein the first portion protrudes from the second surface of the first semiconductor substrate, and the planarized insulating layer surrounds the first portion.

3. The semiconductor device of claim 1 or 2, wherein a difference between the bottom of the conductive through-via and a lowest level of the second surface of the first semiconductor substrate ranges from 2 nm to 15 nm.

4. The semiconductor device of claim 1, 2, or 3, wherein the planarized insulating layer includes SiO₂, SiN, SiCN, SiC, SiCOH, or SiON.

5. The semiconductor device of anyone of claims 1 to 4, further comprising an etch stop layer disposed between the planarized insulating layer and the backside insulating layer.

6. The semiconductor device of claim 5, wherein the etch stop layer includes a compound containing aluminum.

7. The semiconductor device of any one of claims 1 to 6, wherein the contact structure has a portion extending in the second direction and connected to the conductive through-via.

8. The semiconductor device of any one of claims 1 to 7, wherein the front wiring layer has a metal via connected to the conductive through-via.

9. The semiconductor device of any one of claims 1 to 8, wherein the first semiconductor substrate has a thickness of 2 µm or less.

10. The semiconductor device of any one of claims 1 to 9, wherein the backside wiring structure further includes a first bonding pad having a surface substantially coplanar with a surface of the backside insulating layer.

11. The semiconductor device of claim 10, further comprising:
a bonding structure disposed on the backside wiring structure, and having a bonding insulating layer bonded to the backside insulating layer and a second bonding pad embedded in the bonding insulating layer and bonded to the first bonding pad;
a lower wiring structure disposed on the bonding structure and having a lower wiring layer connected to the second bonding pad; and
a second semiconductor substrate disposed on the lower wiring structure.

12. The semiconductor device of claim 11, wherein the second semiconductor substrate includes a contact via penetrating through the second semiconductor substrate and connected to the lower wiring layer.

13. The semiconductor device of claim 11 or 12, wherein the second semiconductor substrate includes a logic device or a memory device.

14. The semiconductor device of any one of claims 1 to 13, further comprising a support substrate disposed on the front wiring structure.

15. The semiconductor device of any one of claims 1 to 14, further comprising a plurality of channel layers stacked on the active pattern in a third direction perpendicular to the first direction and the second direction, and spaced apart from each other,
wherein the gate structure includes a gate electrode surrounding the plurality of channel layers, and a gate insulating film disposed between the plurality of channel layers and the gate electrode.
